# EUROPEAN PATENT APPLICATION

(11) **EP 2 400 590 A1**
(43) Date of publication of application: **28.12.2011**
(21) Application number: 10743818.6
(22) Date of filing: 18.02.2010
(51) Int. Cl.: H01M 14/00, C08G 65/18, C08L 63/00, H01L 31/04, H01M 2/08

(54) **SEALING AGENT FOR DYE-SENSITIZED SOLAR CELL AND DYE-SENSITIZED SOLAR CELL**

(30) Priority: 20.02.2009 JP 2009038069
(71) Applicant: Sekisui Chemical Co., Ltd., Osaka 530-8565 (JP)
(72) Inventor: SHICHIRI Tokushige, Mishima-gun Osaka 618-0021 (JP)
(74) Representative: Hart-Davis, Jason
(86) International application number: PCT/JP2010/052469
(87) International publication number: WO 2010/095692

(57) **Abstract**

An object of the present invention is to provide a sealing agent for a dye-sensitized solar cell, which is excellent in sealability and iodine stain resistance, and to provide a dye-sensitized solar cell produced using the sealing agent for a dye-sensitized solar cell.

The present invention is a sealing agent for a dye-sensitized solar cell, which contains a cationic polymerizable compound and a photo-cationic polymerization initiator, the sealing agent containing 20 to 80 parts by weight of a saturated hydrocarbon compound having an ether structure in a main chain and two or more oxetanyl groups in a molecule, in 100 parts by weight of the cationic polymerizable compound.

## Description

### TECHNICAL FIELD

The present invention relates to a sealing agent for a dye-sensitized solar cell, which is excellent in sealability and iodine stain resistance, and also relates to a dye-sensitized solar cell produced using the sealing agent for a dye-sensitized solar cell.

### BACKGROUND ART

Commonly-used photoelectric cells such as solar cells are of the p-n junction type using silicon semiconductors. Silicon semiconductors used in photoelectric cells need to have high purity and high regularity for enhancing the photoelectric conversion efficiency of the photoelectric cells. However, production of silicon semiconductors and photoelectric cells consumes a large quantity of energy, problematically leading to increase in production cost.

A recently-developed photoelectric cell is a dye-sensitized solar cell in which an electrolyte is injected into a gap between a transparent conductive substrate having a semiconductor film, such as TiO₂ supporting a dye thereon, and a counter electrode substrate. Dye-sensitized solar cells receive much attention as next-generation solar cells because of their comparatively-high solar conversion efficiency.

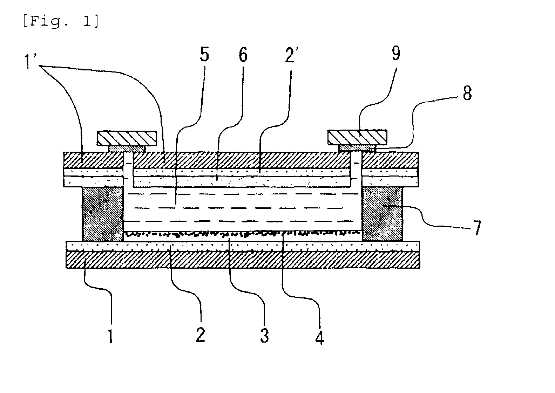

As illustrated in Fig. 1, an exemplary process for producing a dye-sensitized solar cell comprises: forming a transparent electrode layer 2 on a glass substrate 1 as an insulating substrate; forming on the electrode layer 2 a semiconductor layer 3 preliminarily adsorbing a photosensitive dye 4 to produce an electrode substrate as a working electrode; forming a transparent electrode layer 2' on an insulating substrate 1' to produce an electrode substrate as a counter electrode; and injecting an electrolyte 5 into the gap between the two electrodes. A redox-type electrolyte containing iodine is commonly used as the electrolyte 5.
For example, Patent Document 1 discloses a dye-sensitized solar cell comprising a material that is prepared by allowing a semiconductor comprising a metal oxide such as porous and polycrystalline titanium oxide to adsorb a photosensitive dye such as ruthenium metal complex.

A sealing agent is used to enclose the electrolyte. A sealing agent used in producing a dye-sensitized solar cell is required to have enough adhesiveness for preventing leakage of the electrolyte by firmly adhering to the substrate and sufficient moisture impermeability for preventing moisture intrusion from outside (hereinafter, these properties are also referred to as "sealability"). Conventional sealing agents comprising an ethylene-methacrylic acid copolymer ionomer resin problematically allows infiltration of iodine into the sealing agent, which lowers the adhesion due to a reaction between the sealing agent and iodine and also lowers the concentration of iodine in the electrolyte. Accordingly, there have been needs for a sealing agent for a dye-sensitized solar cell which is excellent in sealability and iodine stain resistance.

### PRIOR ART DOCUMENTS

### PATENT DOCUMENTS

Patent Document 1: Japanese Kokai Publication No. Hei-01-220380 (JP-A H01-220380)

### SUMMARY OF THE INVENTION

### PROBLEMS TO BE SOLVED BY THE INVENTION

The object of the present invention is to provide a sealing agent for a dye-sensitized solar cell, which is excellent in sealability and iodine stain resistance, and to provide a dye-sensitized solar cell produced using the sealing agent for a dye-sensitized solar cell.

### PROBLEMS TO BE SOLVED BY THE INVENTION

The present invention is a sealing agent for a dye-sensitized solar cell, which contains a cationic polymerizable compound and a photo-cationic polymerization initiator, the sealing agent containing 20 to 80 parts by weight of a saturated hydrocarbon compound having an ether structure in a main chain and two or more oxetanyl groups in a molecule, in 100 parts by weight of the cationic polymerizable compound.
In the following, the present invention is described in detail.

The present inventors have observed exceptional iodine stain resistance in a sealing agent containing a photo-cationic polymerization initiator and a cationic polymerizable compound that contains a specific amount of a saturated hydrocarbon compound having an ether structure in a main chain and two or more oxetanyl groups in a molecule. The present inventors have also found that such a sealing agent inhibits leakage of an electrolyte and iodine staining even when a redox-type electrolyte containing iodine is used. This allows production of dye-sensitized solar cells having exceptional durability. Accordingly, the present invention was completed.

The sealing agent for a dye-sensitized solar cell of the present invention contains a cationic polymerizable compound.
The cationic polymerizable compound contains a saturated hydrocarbon compound having an ether structure in a main chain and two or more oxetanyl groups in a molecule.
The saturated hydrocarbon compound having an ether structure in a main chain and two or more oxetanyl groups in a molecule allows the sealing agent for a dye-sensitized solar cell of the present invention to be excellent in sealability and iodine stain resistance.

Though not particularly limited, the saturated hydrocarbon compound having an ether structure in a main chain and two or more oxetanyl groups in a molecule preferably has a structure represented by the following formula (1).

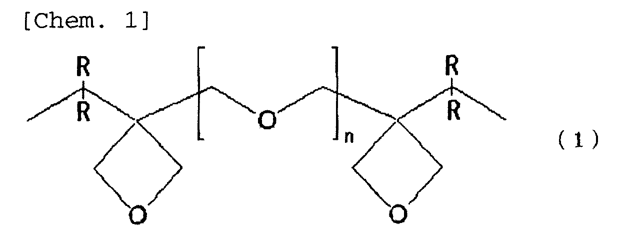

In the formula (1), R represents hydrogen or an alkyl group containing 1 to 6 carbon atoms and n represents an integer from 1 to 12.
Here, R is preferably hydrogen.

Specific examples of the saturated hydrocarbon compound having an ether structure in a main chain and two or more oxetanyl groups in a molecule include di{1-ethyl(3-oxetanyl)}methyl ether.

Examples of a commercially-available saturated hydrocarbon compound having an ether structure in a main chain and two or more oxetanyl groups in a molecule include ARONE OXETANE OXT-221 (product of TOAGOSEI CO., LTD.).

The amount of the saturated hydrocarbon compound having an ether structure in a main chain and two or more oxetanyl groups in a molecule is 20 parts by weight in the lower limit and 80 parts by weight in the upper limit, for 100 parts by weight of the cationic polymerizable compound. An amount of less than 20 parts by weight does not provide sufficient effects of preventing intrusion of water and of inhibiting the leakage of the electrolyte and iodine staining. As a result, the obtainable dye-sensitized solar cell has poor durability. In contrast, an amount of more than 80 parts by weight lowers the viscosity of the obtainable sealing agent for a dye-sensitized solar cell. Such a sealing agent fails to maintain its shape after being applied. Further, the cured substance of the obtainable sealing agent for a dye-sensitized solar cell has a lower glass transition temperature, which causes leakage of iodine and a solvent at heating when such a sealing agent is used in a dye-sensitized solar cell. Preferably, the lower limit is 30 parts by weight and the upper limit is 70 parts by weight. More preferably, the lower limit is 40 parts by weight and the upper limit is 60 parts by weight.

Though not particularly limited, another component further contained in the cationic polymerizable compound, in addition to the saturated hydrocarbon compound having an ether structure in a main chain and two or more oxetanyl groups in a molecule, is preferably an epoxy compound having a saturated polycyclic hydrocarbon group or two or more cyclohexyl groups in a repeating unit. The epoxy compound having a saturated polycyclic hydrocarbon group or two or more cyclohexyl groups in a repeating unit increases the viscosity of the obtainable sealing agent for a dye-sensitized solar cell and the glass transition temperature of the cured substance of the sealing agent. This prevents easy permeation of the electrolyte or lowering of the adhesion which may be caused by the sealing agent softened by temperature rise of the dye-sensitized solar cell.

Though not particularly limited, the epoxy compound having a saturated polycyclic hydrocarbon group or two or more cyclohexyl groups in a repeating unit is preferably at least one compound selected from the group consisting of compounds represented by the following formulae (2-1), (2-2), and (2-3).

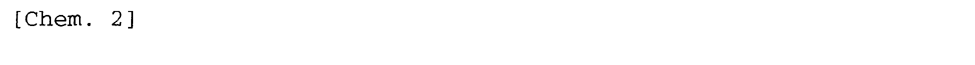

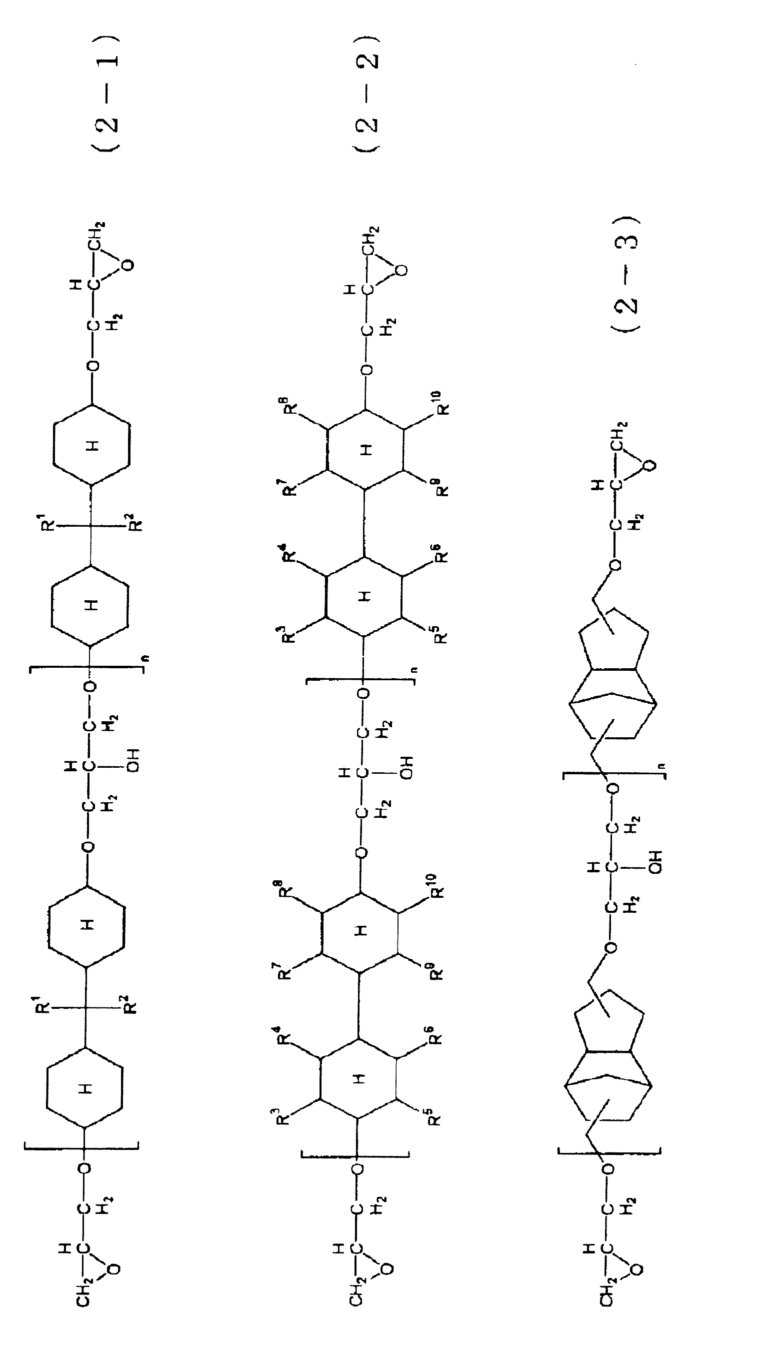

In the formula (2-1), n represents an integer from 0 to 20, and R¹ and R² each represent hydrogen or a linear or branched alkyl group containing 1 to 12 carbon atoms.
In the formula (2-2), n represents an integer from 0 to 20, and R³ to R¹⁰ each represent hydrogen or a linear or branched alkyl group containing 1 to 12 carbon atoms.
In the formula (2-3), n represents an integer from 0 to 20.

Examples of the epoxy compound having a saturated polycyclic hydrocarbon group or two or more cyclohexyl groups in a repeating unit include a hydrogenated bisphenol A-type resin, a hydrogenated bisphenol F-type resin, a hydrogenated biphenyl-type resin, and a dicyclopentadiene-type epoxy. Commercially-available compounds among these include Epicoat YX-8000 (hydrogenated bisphenol A-type resin), Epicoat YX-6753 (hydrogenated bisphenol F-type resin), Epicoat YL-6800 (hydrogenated biphenyl-type resin) (products of Japan Epoxy Resin Co., Ltd.), and Adeka resin EP-4088 (dicyclopentadiene-type epoxy, product of TOAGOSEI Co., Ltd.).

Preferably, the amount of the epoxy compound having a saturated polycyclic hydrocarbon group or two or more cyclohexyl groups in a repeating unit is 80 parts by weight in the upper limit, for 100 parts by weight of the cationic polymerizable compound. An amount of more than 80 parts by weight may lower the iodine stain resistance.

The cationic polymerizable compound may further contain an epoxy compound having a hydroxyl group or an oxetane compound having a hydroxyl group. The epoxy compound having a hydroxyl group or the oxetane compound having a hydroxyl group allows the sealing agent for a dye-sensitized solar cell of the present invention to exert higher adhesiveness.

The epoxy compound having a hydroxyl group or the oxetane compound having a hydroxyl group is not particularly limited. Examples thereof include glycidol, 3-methyl-3-hydroxymethyloxetane, and 3-ethyl-3-hydroxymethyloxetane. Among these, 3-ethyl-3-hydroxymethyloxetane is preferable.
Examples of commercially-available compounds of the epoxy compound having a hydroxyl group or the oxetane compound having a hydroxyl group include Eternacoll EHO (3-ethyl-3-hydroxymethyloxetane, product of Ube industries, Ltd.), and OXT-101 (3-ethyl-3-hydroxymethyloxetane, product of TOAGOSEI Co., Ltd.).

Preferably, the amount of the epoxy compound having a hydroxyl group or the oxetane compound having a hydroxyl group is 30 parts by weight in the upper limit, for 100 parts by weight of the cationic polymerizable compound. An amount of more than 30 parts by weight may lead to higher hydrophilicity, resulting in lowered moisture impermeability.

The cationic polymerizable compound may further contain an epoxy compound having a silicone skeleton or an oxetane compound having a silicone skeleton. The epoxy compound having a silicone skeleton or the oxetane compound having a silicone skeleton allows the sealing agent for a dye-sensitized solar cell of the present invention to exert iodine stain resistance.

Though not particularly limited, the epoxy compound having a silicone skeleton or the oxetane compound having a silicone skeleton is preferably a reactive silicone compound represented by the formula (3).

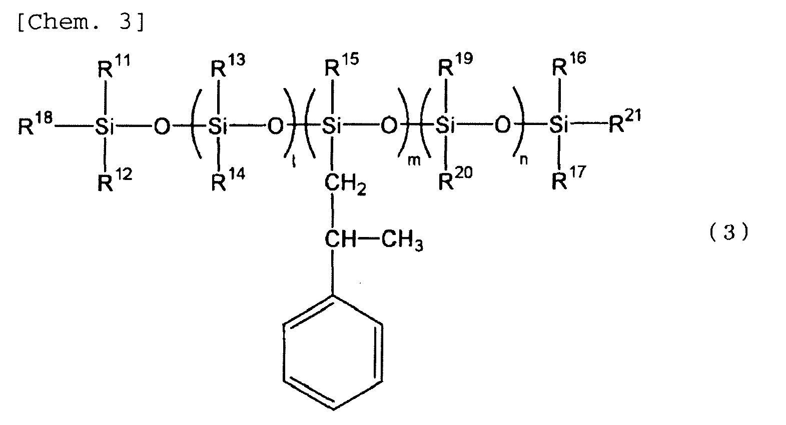

In the formula (3), 1 and m each represents an integer not smaller than 0 and 1 + m = 1 to 100, n represents an integer from 1 to 100, and R¹¹ to R¹⁷ each represents hydrogen, a methyl group, or an ethyl group. At least one of R¹⁸ to R²¹ represents a reactive group selected from the formula (4). The rest of R¹⁸ to R²¹ each represents hydrogen, a methyl group, or an ethyl group.

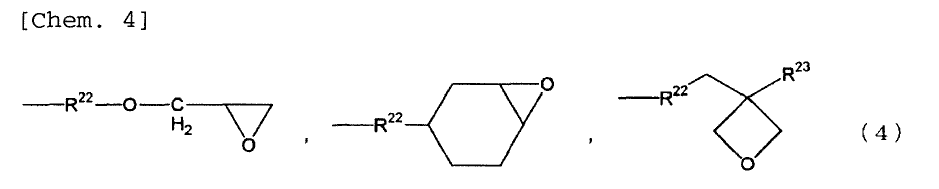

In the formula (4), R²² represents any one of the structures selected form the group consisting of the formulae (5-1), (5-2), and (5-3). R²³ represents hydrogen, a halogen atom, or a linear or branched alkyl group containing 1 to 20 carbon atoms.

[Chem. 5] (CH₂O)_{q} (5 - 1)

(CH₂)ᵣ (5 - 2)

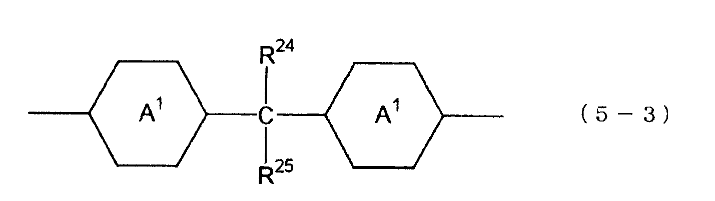

In the formula (5-1), q represents an integer from 1 to 3. In the formula (5-2), r represents an integer from 1 to 3. In the formula (5-3), R²⁴ and R²⁵ each represents hydrogen or a methyl group, and A¹ represents a benzene ring or a cyclohexane ring.

Preferably, the amount of the epoxy compound having a silicone skeleton or the oxetane compound having a silicone skeleton is 50 parts by weight in the upper limit, for 100 parts by weight of the cationic polymerizable compound. An amount of more than 50 parts by weight may lower the moisture impermeability.

Examples of commercially-available compounds of the epoxy compound having a silicone skeleton or the oxetane compound having a silicone skeleton include OX-SC (oxetane silicate) and OX-SQ (oxetane modified silsesquioxane) (products of TOAGOSEI Co., Ltds.), and X-22-3000T (product of Shin-Etsu Chemical Co., Ltd.).

The cationic polymerizable compound may contain epoxy resins to the extent that will not impair the effect of the present invention. Examples of the epoxy resins include: bisphenol-type resins such as bisphenol A-type epoxy resins and bisphenol F-type epoxy resins; novolac-type epoxy resins such as phenol novolac-type epoxy resins and cresol novolac-type epoxy resins; alicyclic epoxy resins; heterocyclic epoxy resins; aromatic epoxy resins such as biphenyl-type epoxy resins and anthracene-type epoxy resins; halogenated epoxy resins such as brominated epoxy resins; and other epoxy resins such as rubber modified epoxy resins, urethane modified epoxy resins, epoxidized polybutadiene, epoxydized styrene-butadiene-styrene block copolymers, epoxy group-containing polyester resins, epoxy group-containing polyurethane resins, and epoxy group-containing acrylic resins.

The sealing agent for a dye-sensitized solar cell of the present invention contains a cationic polymerization initiator. The cationic polymerization initiator is not particularly limited, provided that it generates protonic acids or Lewis acids by irradiation with light. It may be of the ionic or nonionic photoacid generation type.

The cationic polymerization initiator is not particularly limited, and examples thereof include iodonium salts and sulfonium salts.
The iodonium salts are not particularly limited, and examples thereof include (tolylcumyl)iodonium tetrakis (pentafluorophenyl)borate.
The sulfonium salts are not particularly limited, and examples thereof include diphenyl-4-thiophenylsulfonium-hexafluoroantimonate.

Examples of commercially-available cationic polymerization initiators include RP2074 (product of Rhodia Japan Ltd.) and SP-170 (product of ADEKA Corporation).

Though not particularly limited, preferably, the amount of the cationic polymerization initiators is 0.1 parts by weight in the lower limit and 10 parts by weight in the upper limit, for 100 parts by weight of the cationic polymerizable compound. An amount of less than 0.1 parts by weight may cause insufficient cationic polymerization of the cationic polymerizable compound or too slow curing of the obtainable sealing agent for a dye-sensitized solar cell. In contrast, the amount of more than 10 parts by weight may cause too fast curing of the obtainable sealing agent for a dye-sensitized solar cell, leading to lowered operability and non-uniform cured substances of the obtainable sealing agent for a dye-sensitized solar cell. More preferably, the lower limit is 0.3 parts by weight and the upper limit is 5 parts by weight.

The sealing agent for a dye-sensitized solar cell of the present invention preferably further contains a filler.
The filler enhances moisture impermeability and adhesiveness of the obtainable sealing agent for a dye-sensitized solar cell and reduces cure shrinkage and thermal expansion of the obtainable sealing agent for a dye-sensitized solar cell.

The filler is not particularly limited, and examples thereof include powder, inorganic hollow bodies, organic spheres, organic hollow bodies, and monofilament.
The powder is not particularly limited, and examples thereof include colloidal silica, talc, mica, calcium carbonate, titanium oxide, and clay.
The inorganic hollow bodies are not particularly limited, and examples thereof include glass balloon, alumina balloon, and ceramic balloon.
The organic spheres are not particularly limited, and examples thereof include nylon beads, acrylic beads, silicon beads, and fluororesin beads.
The organic hollow bodies are not particularly limited, and examples thereof include vinylidene chloride balloon and acrylic balloon.
The monofilament is not particularly limited, and examples thereof include glass, polyester, rayon, nylon, and cellulose.

The filler is preferably inorganic tabular powder. The filler made of inorganic tabular powder allows the sealing agent for a dye-sensitized solar cell of the present invention to exert higher moisture impermeability.
Examples of the inorganic tabular powder include alumina, talc, and mica.
The inorganic tabular powder in the present description is defined to have an average ratio of the length (a) and the breadth (b), namely (a/b), of 10 or less and an average ratio of the length (a) and the thickness (c), namely (a/c), of 10 or more.

In the case that the filler has an average ratio of (a/b) of more than 10, the filler is nearly rod-like or fibrous. This may make the sealing agent for a dye-sensitized solar cell of the present invention have insufficient moisture impermeability. The upper limit of the average ratio of (a/b) is preferably 5.
In the case that the filler has an average ratio of (a/c) of less than 10, the filler is nearly spherical or cubic. This may make the sealing agent for a dye-sensitized solar cell of the present invention have insufficient moisture impermeability. The lower limit of the average ratio of (a/c) is preferably 12.
Such a filler not only enhances the moisture impermeability of the sealing agent for a dye-sensitized solar cell of the present invention as mentioned above, but also provides enhanced adhesiveness and thixotropy to the obtainable sealing agent.
Here, the average ratio of the length (a) and the breadth (b), namely (a/b), and the average ratio of the length (a) and the thickness (c), namely (a/c), can be measured using a scanning electron microscope (SEM), for example.

Preferably, the average particle size of the filler measured by the microtrac particle size analyzer is 1 µm in the lower limit and 50 µm in the upper limit. In the case that the average particle size measured by the microtrac particle size analyzer is less than 1 µm, such a filler may have too small a particle size and have a nearly spherical shape. This may make the sealing agent for a dye-sensitized solar cell of the present invention have insufficient moisture impermeability. In the case that the average particle size measured by the microtrac particle size analyzer is more than 50 µm, such filler particles may be obstacles to each other in the sealing agent for a dye-sensitized solar cell of the present invention, leading to non-uniform dispersion thereof. This may lower the moisture impermeability of the sealing agent for a dye-sensitized solar cell of the present invention. The upper limit of the average particle size of the filler measured by the microtrac particle size analyzer is preferably 30 µm.

The filler may be surface-treated or surface-untreated. Examples of the surface-treated fillers include methoxylated fillers, trimethylsilylated fillers, octylsilylated fillers and fillers which are surface-treated with silicone oil. Each of these fillers may be used alone, or two or more of these may be used in combination.

Though not particularly limited, preferably, the lower limit of the amount of the filler is 0.3 parts by weight and the upper limit thereof is 100 parts by weight, for 100 parts by weight of the cationic polymerizable compound. An amount of less than 0.3 parts by weight may fail to sufficiently exert the effect of enhancing moisture impermeability and adhesiveness of the obtainable sealing agent for a dye-sensitized solar cell and reducing cure shrinkage and thermal expansion of the obtainable sealing agent for a dye-sensitized solar cell. An amount of more than 100 parts by weight may cause too slow curing of the obtainable sealing agent for a dye-sensitized solar cell. More preferably, the upper limit of the amount of the filler is 3 parts by weight.

The sealing agent for a dye-sensitized solar cell of the present invention preferably further contains a silane coupling agent.
The silane coupling agent enhances the adhesiveness of the obtainable sealing agent for a dye-sensitized solar cell in a high-humidity environment.

The silane coupling agent is not particularly limited, and examples thereof include γ-aminopropyltrimethoxysilane, γ-mercaptopropyltrimethoxysilane, γ-glycidoxypropyltrimethoxysilane, and γ-isocyanatepropyltrimethoxysilane. Each of these silane coupling agent may be used alone, or two or more of these may be used in combination.

Though not particularly limited, the lower limit of the amount of the silane coupling agent is preferably 0.3 parts by weight and the upper limit thereof is preferably 10 parts by weight, for 100 parts by weight of the cationic polymerizable compound. An amount of less than 0.3 parts by weight may fail to sufficiently exert the effect of improving moisture impermeability, adhesiveness, cure shrinkage and thermal expansion of the obtainable sealing agent for a dye-sensitized solar cell. An amount of more than 10 parts by weight may cause too slow curing of the obtainable sealing agent for a dye-sensitized solar cell. More preferably, the lower limit of the amount of the silane coupling agent is 0.5 parts by weight and the upper limit thereof is 5 parts by weight.

The sealing agent for a dye-sensitized solar cell of the present invention preferably further contains a cure retarder.
The cure retarder retards photo-cationic polymerization of the cationic polymerizable compound. Therefore, the obtainable sealing agent for a dye-sensitized solar cell has excellent delay-photocurability. This allows optional control of the pot life after the irradiation with light. Accordingly, a light-blocking substrate such as a metal board is usable as a substrate of a dye-sensitized solar cell, which expands the range of substrate selection.

The cure retarder is not particularly limited, and examples thereof include a compound having an ether skeleton and aliphatic hydrocarbon having a hydroxyl group. Among these, a compound having an ether skeleton is preferably used as it well retards photo-cationic polymerization of the cationic polymerizable compound. Each of these cure retarders may be used alone, or two or more of these may be used in combination.

The compound having an ether skeleton is not particularly limited, and examples thereof include polyalkylene oxides, crown ethers, and polyalkylene oxide-added bisphenol derivatives.

The polyalkylene oxides are not particularly limited, and examples thereof include polyethylene glycol, polypropylene glycol, and polyoxytetramethylene glycol.
Each of these compounds having an ether skeleton may be used alone, or two or more of these may be used in combination.

Ends of the polyalkylene oxides are not particularly limited, and may be hydroxyl groups, functional groups such as epoxy groups, or etherified or esterified by another compound. Particularly, ends of the polyalkylene oxides are preferably hydroxyl or epoxy groups as they are reactive with the cationic polymerizable compound.

The crown ethers are not particularly limited, and examples thereof include 18-crown-6, 15-crown-5, and 12-crown-4.

Though not particularly limited, the polyalkylene oxide-added bisphenol derivatives preferably have hydroxyl or epoxy groups at their ends. Though not particularly limited, examples of commercially-available polyalkylene oxide-added bisphenol derivatives include "RIKARESIN"s such as "RIKARESIN BPO-20E", "RIKARESIN BEO-60E", and "RIKARESIN PO-20" produced by New Japan Chemical co., ltd.

The aliphatic hydrocarbon having a hydroxyl group is not particularly limited, and examples thereof include polyfunctional hydroxyl group-containing compounds such as glycerin and pentaerythritol. Each of these aliphatic hydrocarbons having a hydroxyl group may be used alone, or two or more of these may be used in combination.

The amount of the cure retarder may be determined in accordance with the required pot life after the irradiation with light and is not particularly limited. Preferably, the lower limit thereof is 0.1 parts by weight and the upper limit thereof is 10 parts by weight, for 100 parts by weight of the cationic polymerizable compound. An amount of less than 0.1 parts by weight may result in an insufficient pot life of the obtainable sealing agent for a dye-sensitized solar cell. An amount of more than 10 parts by weight may cause too slow curing of the obtainable sealing agent for a dye-sensitized solar cell. More preferably, the lower limit of the amount of the cure retarder is 0.3 parts by weight and the upper limit thereof is 5 parts by weight.

The sealing agent for a dye-sensitized solar cell of the present invention preferably further contains a photosensitizer. The photosensitizer further improves the polymerization initiation efficiency of the photo-cationic polymerization initiator and accelerates the curing reaction of the sealing agent for a dye-sensitized solar cell of the present invention.

The photosensitizer is not particularly limited, and examples thereof include 2,2-dimethoxy-1,2-diphenylethane-1-on, benzophenone, 2,4-dichlorobenzophenone, methyl o-benzoylbenzoate, 4,4-bis(dimethylamino)benzophenone, 4-benzoyl-4'methyldiphenylsulfide, and thioxanthone compounds.

Though not particularly limited, the lower limit of the amount of the photosensitizer is preferably 0.03 parts by weight and the upper limit thereof is preferably 2 parts by weight for 100 parts by weight of the photo-cationic polymerizable compound. An amount of less than 0.03 parts by weight may result in insufficient sensitization. An amount of more than 2 parts by weight may cause too much photoabsorption, leading to a case that light fails to reach a deep portion. More preferably, the lower limit of the amount of the photosensitizer is 0.05 parts by weight and the upper limit thereof is 1 part by weight.

The sealing agent for a dye-sensitized solar cell of the present invention preferably further contains additives commonly used in sealing agents for a dye-sensitized solar cell such as silicone defoaming agents, fluorine defoaming agents, antioxidants, and photostabilizers.

A method for producing the sealing agent for a dye-sensitized solar cell of the present invention is not particularly limited, and examples thereof include a method of mixing the cationic polymerizable compound, the photo-cationic polymerization initiator, and optional additives using a mixing machine such as homodispers, homomixers, universal mixers, planetary mixers, kneaders, and three-roll mills.

Though not particularly limited, the lower limit of the viscosity of the sealing agent for a dye-sensitized solar cell of the present invention is preferably 100 mPa·s and the upper limit thereof is preferably 500 Pa·s. A viscosity of less than 100 mPa·s may make the obtainable sealing agent for a dye-sensitized solar cell fail to maintain its shape after being applied. A viscosity of more than 500 Pa·s may not allow uniform application of the obtainable sealing agent. More preferably, the lower limit of the viscosity is 500 mPa·s and the upper limit thereof is 300 Pa·s.

After the application of the sealing agent for a dye-sensitized solar cell of the present invention to a substrate and the like, the sealing agent is cured by irradiation with light, which allows bonding of substrates and enclosing of an electrolyte.

A method of applying the sealing agent for a dye-sensitized solar cell of the present invention is not particularly limited, and the application may be carried out using coating machines such as dispensers, roll coaters, and die coaters, or printers such as screen printers.

A light source for irradiating the sealing agent for a dye-sensitized solar cell of the present invention is not particularly limited. Examples thereof include low-, medium-, high-, and ultra-high-pressure mercury lamps, excimer lasers, chemical lamps, black-light lamps, microwave-excited mercury lamps, metal halide lamps, sodium lamps, halogen lamps, xenon lamps, fluorescent lamps, sunlight, electron beam processing systems and the like. Each of these light sources may be used alone, or two or more of these may be used in combination. The light source is appropriately selected in accordance with the absorption wavelength of the cationic polymerization initiator.

Though not particularly limited, preferably, the lower limit of the wavelength of light irradiating the sealing agent for a dye-sensitized solar cell is 250 nm and the upper limit thereof is 450 nm. A wavelength of less than 250 nm may cause degradation of resins and the like.
A wavelength of more than 450 nm may fail to provide sufficient energy needed for activating the initiator.
More preferably, the lower limit of the wavelength of light is 300 nm and the upper limit thereof is 400 nm.

Though not particularly limited, preferably, the lower limit of the accumulation of light irradiating the sealing agent for a dye-sensitized solar cell is 100 mJ/cm² and the upper limit thereof is 10000 mJ/cm². An accumulation of less than 100 mJ/cm² may fail to sufficiently cure the sealing agent for a dye-sensitized solar cell. An accumulation of more than 10000 mJ/cm² does not further contribute to the curing and may lead to degradation of the sealing agent and other members. More preferably, the lower limit of the accumulation is 300 mJ/cm² and the upper limit thereof is 6000 mJ/cm².
The procedure of irradiating the sealing agent for a dye-sensitized solar cell with the light source is not particularly limited. Examples thereof include simultaneous irradiation, sequential irradiation at predetermined time intervals, and combination of simultaneous irradiation and sequential irradiation using various light sources.

The sealing agent for a dye-sensitized solar cell of the present invention may be heated simultaneously with or after the irradiation with light during the curing of the sealing agent for a dye-sensitized solar cell of the present invention. This accelerates photo-cationic polymerization of the cationic polymerizable compound so that the curing time is further shortened. Though not particularly limited, the heating temperature is preferably about 50 to 100°C.

Though not particularly limited, the lower limit of the glass transition temperature of the cured substance of the sealing agent for a dye-sensitized solar cell of the present invention is preferably 80°C. A glass transition temperature of lower than 80°C may allow easy permeation of the electrolyte or lowering of the adhesion which may be caused by the sealing agent softened by temperature rise of the dye-sensitized solar cell.

Exemplary methods of bonding substrates for a dye-sensitized solar cell using the sealing agent for a dye-sensitized solar cell of the present invention include a method comprising the steps of: applying the sealing agent to at least one of two substrates to be attached; attaching the two substrates to each other; and irradiating the attached substrates with light to cure the sealing agent.

When the sealing agent for a dye-sensitized solar cell of the present invention contains a cure retarder, the substrates may be attached to each other after the irradiation with light and before the sealing agent is cured. More specifically, the sealing agent for a dye-sensitized solar cell of the present invention is applied to at least one of two substrates to be attached and the applied sealing agent is irradiated with light. Then, the two substrates are attached to each other and heated so that the sealing agent is cured. Or alternatively, after being irradiated with light, the sealing agent for a dye-sensitized solar cell of the present invention is applied to at least one of two substrates to be attached. Then, the two substrates are attached to each other and heated so that the sealing agent is cured. Accordingly, the substrates are bonded to each other.

As above, when the sealing agent for a dye-sensitized solar cell of the present invention contains a cure retarder, the sealing agent does not have to be irradiated with light through the substrate. Therefore, the substrates can be bonded to each other without difficulty even when the two substrates are non-light transmissive.
In addition, it is possible to prevent degradation of dyes on the substrates which may be influenced by light.

The present invention also provides a dye-sensitized solar cell obtained using the sealing agent for a dye-sensitized solar cell of the present invention.
Since the sealing agent for a dye-sensitized solar cell of the present invention is used to produce the dye-sensitized solar cell of the present invention, the dye-sensitized solar cell has excellent durability even when a redox-type electrolyte containing iodine is used.

### EFFECT OF THE INVENTION

The present invention provides a sealing agent for a dye-sensitized solar cell, which is excellent in sealability and iodine stain resistance, and also provides a dye-sensitized solar cell produced using the sealing agent for a dye-sensitized solar cell.

### BRIEF DESCRIPTION OF THE DRAWING

[Fig. 1]
   Fig. 1 is a schematic view illustrating the configuration of a dye-sensitized solar cell.

### MODES FOR CARRYING OUT THE INVENTION

Hereinafter, the present invention will be described in more detail by way of examples, but the present invention is not limited to these examples.

### (Example 1)

A sealing agent for a dye-sensitized solar cell was prepared by uniformly stirring: 50 parts by weight of di{1-ethyl(3-oxetanyl)}methyl ether (product of TOAGOSEI CO., LTD., "ARON OXETANE OXT-221") and 50 parts by weight of a hydrogenated bisphenol A-type epoxy resin (product of Japan Epoxy Resin Co., Ltd., "YX-8034") as cationic polymerizable compounds; 1 part by weight of (tolylcumyl)iodonium tetrakis (pentafluorophenyl)borate (product of Rhodia Japan Ltd., "RP2074") as a photo-cationic polymerization initiator; 1 part by weight of γ-glycidoxypropyltrimethoxysilane (product of Shin-Etsu Chemical Co., Ltd., "KBM-403") as a silane coupling agent; and 0.2 parts by weight of a thioxanthone compound (product of NIPPON KAYAKU Co., Ltd., "DETX-S") as a photosensitizer, using a homodisper-type stirring machine (product of Tokushu Kika Kogyo Co., Ltd., "homodisper L type") at a stirring rate of 3000 rpm.

### (Example 2)

A sealing agent for a dye-sensitized solar cell was prepared in the same manner as in Example 1, except that 30 parts by weight of talc particles (product of Nippon Talc Co., Ltd., "MICRO ACE SG-100", average particle size: 5.4 µm, average ratio (a/b) of the length (a) and the breadth (b): 10, average ratio (a/c) of the length (a) and the thickness (c): 25) as a filler was added.

### (Example 3)

A sealing agent for a dye-sensitized solar cell was prepared in the same manner as in Example 1, except that 50 parts by weight of a dicyclopentadiene-type epoxy resin (product of ADEKA CORPORATION, "HP-4088") was used instead of 50 parts by weight of the hydrogenated bisphenol A-type epoxy resin, and that 30 parts by weight of talc particles as a filler was added.

### (Example 4)

A sealing agent for a dye-sensitized solar cell was prepared in the same manner as in Example 1, except that the amounts of di{1-ethyl(3-oxetanyl)}methyl ether and the hydrogenated bisphenol A-type epoxy resin were respectively adjusted to 80 parts by weight and 20 parts by weight, and that 30 parts by weight of talc particles as a filler was added.

### (Example 5)

A sealing agent for a dye-sensitized solar cell was prepared in the same manner as in Example 1, except that that the amounts of di{1-ethyl(3-oxetanyl)}methyl ether and the hydrogenated bisphenol A-type epoxy resin were respectively adjusted to 20 parts by weight and 80 parts by weight, and that 30 parts by weight of talc particles as a filler was added.

### (Example 6)

A sealing agent for a dye-sensitized solar cell was prepared in the same manner as in Example 1, except that the amounts of di{1-ethyl(3-oxetanyl)}methyl ether, the hydrogenated bisphenol A-type epoxy resin, and oxetane silicate (product of TOAGOSEI CO., LTD., "OX-SC") were respectively adjusted to 20 parts by weight, 60 parts by weight, and 20 parts by weight, and that 30 parts by weight of talc particles as a filler was added.

### (Example 7)

A sealing agent for a dye-sensitized solar cell was prepared in the same manner as in Example 1, except that 1 part by weight of 18-crown-6 (product of Wako Pure Chemical Industries Ltd.) as a cure retarder and 30 parts by weight of talc particles as a filler were added.

### (Example 8)

A sealing agent for a dye-sensitized solar cell was prepared in the same manner as in Example 2, except that the amount of the hydrogenated bisphenol A-type epoxy resin was adjusted to 40 parts by weight and 10 parts by weight of 3-ethyl-3-hydroxymethyl oxetane was added.

### (Example 9)

A sealing agent for a dye-sensitized solar cell was prepared in the same manner as in Example 1, except that 30 parts by weight of plate-like mica (product of YAMAGUCHI MICA CO., LTD., "SJ-005", average particle size: 5 µm, average ratio (a/b): 5, average ratio (a/c): 60) as a filler was added.

### (Example 10)

A sealing agent for a dye-sensitized solar cell was prepared in the same manner as in Example 1, except that 30 parts by weight of spherical silica particles (product of Tokuyama Corporation, "FINESIL X-45", average particle size: 4.5 µm) as a filler was added.

### (Example 11)

A sealing agent for a dye-sensitized solar cell was prepared in the same manner as in Example 1, except that 0.2 parts by weight of the thioxanthone compound (product of NIPPON KAYAKU Co., Ltd., "DETX-S") as a sensitizer was not used and 30 parts by weight of talc particles as a filler was added.

### (Comparative Example 1)

A sealing agent for a dye-sensitized solar cell was prepared in the same manner as in Example 1, except that the amounts of di{1-ethyl(3-oxetanyl)}methyl ether and the hydrogenated bisphenol A-type epoxy resin were respectively adjusted to 10 parts by weight and 90 parts by weight, and that 30 parts by weight of talc particles as a filler was added.

### (Comparative Example 2)

A sealing agent for a dye-sensitized solar cell was prepared in the same manner as in Example 1, except that the amounts of di{1-ethyl(3-oxetanyl)}methyl ether and the hydrogenated bisphenol A-type epoxy resin were respectively adjusted to 90 parts by weight and 10 parts by weight, and that 30 parts by weight of talc particles as a filler was added.

### (Comparative Example 3)

A sealing agent for a dye-sensitized solar cell was prepared in the same manner as in Example 1, except that 50 parts by weight of the dicyclopentadiene-type epoxy resin was used instead of 50 parts by weight of di{1-ethyl(3-oxetanyl)}methyl ether, and 30 parts by weight of talc particles as a filler was added.

### (Comparative Example 4)

A sealing agent for a dye-sensitized solar cell was prepared in the same manner as in Example 1, except that 50 parts by weight of oxetane silicate was used instead of 50 parts by weight of di{1-ethyl(3-oxetanyl)}methyl ether and '30 parts by weight of talc particles as a filler was added.

### (Comparative Example 5)

A sealing agent for a dye-sensitized solar cell was prepared in the same manner as in Example 1, except that 30 parts by weight of tetramethyleneglycol diglycidyl ether was used instead of 50 parts by weight of di{1-ethyl(3-oxetanyl)}methyl ether, that the amount of the hydrogenated bisphenol A-type epoxy resin was adjusted to 70 parts by weight, and that 30 parts by weight of talc particles as a filler was added.

### (Comparative Example 6)

A sealing agent for a dye-sensitized solar cell was prepared in the same manner as in Example 1, except that 100 parts by weight of a bisphenol A-type epoxy resin (product of Japan Epoxy Resin Co., Ltd., "Epicoat 828") was used instead of 50 parts by weight of di{1-ethyl(3-oxetanyl)}methyl ether and 50 parts by weight of the hydrogenated bisphenol A-type epoxy resin, and that 30 parts by weight of talc particles as a filler was added.

### (Comparative Example 7)

A sealing agent for a dye-sensitized solar cell was prepared in the same manner as in Example 1, except that 50 parts by weight of the hydrogenated bisphenol A-type epoxy resin (product of Japan Epoxy Resin Co., Ltd., "YX-8034") and 50 parts by weight of 1,4-bis{[(3-ethyl-3-oxetanyl)methoxy]methyl} benzene (product of TOAGOSEI CO., LTD., "XDO") were used instead of 50 parts by weight of di{1-ethyl(3-oxetanyl)}methyl ether and 50 parts by weight of the hydrogenated bisphenol A-type epoxy resin, and that 30 parts by weight of talc particles as a filler was added.

### (Evaluation)

The sealing agents for a dye-sensitized solar cell obtained in Examples and Comparative Examples were evaluated with regard to the following items. Tables 1 and 2 show the results.

### (1) Iodine stain resistance

The sealing agents for a dye-sensitized solar cell obtained in Examples and Comparative Examples were applied to PET films using a baker applicator. The PET films were irradiated with UV rays of 365 nm and 3000 mJ/cm² using high-pressure mercury lamps, and then, heated at 80°C for 30 minutes. In this manner, films each with a layer of a cured substance of the sealing agent for a dye-sensitized solar cell were obtained.
An amount of 1 g of each obtained film with a layer of a cured substance of the sealing agent for a dye-sensitized solar cell was immersed in 3-methoxypropionitrile containing 0.05 mol% of iodine. The film was heated in an oven at 85°C for 24 hours. The color change caused by iodine staining the cured substance of the sealing agent for a dye-sensitized solar cell was visually observed. Almost no change in color was evaluated as "⊚". Slight staining was evaluated as "○". Color change to light brown is evaluated as "△". Color change to thick brown is evaluated as "x".

### (2) Sealability

Each of the sealing agents for a dye-sensitized solar cell obtained in Examples and Comparative Examples was applied to the periphery of a glass substrate except for an opening portion thereof using a dispenser. Another glass substrate having a transparent conductive electrode film was attached to the substrate in a manner that the surface with the transparent conductive electrode film faced inward. The attached substrates were irradiated with UV rays of 365 nm and 3000 mJ/cm². The substrates were then heated at 80°C for 30 minutes so that the attached peripheries were sealed. Only the sealing agent for a dye-sensitized solar cell obtained in Example 7 was applied to the periphery of a glass substrate except for an opening portion thereof using a disperser, and the substrate was then irradiated with UV rays of 365 nm and 1500 mJ/cm². After that, another glass substrate having a transparent conductive electrode film was attached to the substrate in a manner that the surface with the transparent conductive electrode film faced inward. Then, the substrates were heated at 80°C for 30 minutes so that the attached peripheries were sealed by delay-curing. Then, a 3-methoxypropionitrile solution containing 0.05 mol% of iodine as an electrolyte was injected through the opening portion and Photorec A-783 (product of Sekisui Chemical Co., Ltd.) as a sealant was further injected through the opening portion. The sealant was cured by irradiation (3000 mJ/cm²) with UV rays of 365 nm to seal the opening portion. In this manner, a dye-sensitized solar cell was assembled. The following two durability tests were carried out to evaluate the sealability of each of the obtained dye-sensitized solar cells.

### (Durability test 1)

The obtained dye-sensitized solar cells were heated in an oven at 85°C for 500 hours. Tables 1 and 2 each show the ratios in percentage of the weight of the electrolytes after the heating to the weight of the electrolytes before the heating.

### (Durability test 2)

The obtained dye-sensitized solar cells were heated in a constant temperature and humidity oven at a temperature of 85°C and a relative humidity of 85% for 500 hours. Tables 1 and 2 each show the ratios in percentage of the weight of the electrolytes after the heating to the weight of the electrolytes before the heating. Here, the increase in weight in the present test means absorption of moisture by the electrolyte.

**[Table 1]**

| | | | Example 1 | Example 2 | Example 3 | Example 4 | Example 5 | Example 6 | Example 7 | Example 8 | Example 9 | Example 10 | Example 11 |
|---|---|---|---|---|---|---|---|---|---|---|---|---|---|
| | | Di(1-ethyl(3-oxetanyl)} methyl ether | 50 | 50 | 50 | 80 | 20 | 20 | 50 | 50 | 50 | 50 | 50 |
| | | Hydrogenated bisphenol A-type epoxy resin | 50 | 50 | - | 20 | 80 | 60 | 50 | 40 | 50 | 50 | 50 |
| | | Dicyclopentadiene-type epoxy resin | - | - | 50 | - | - | - | - | - | - | - | - |
| | | Oxetane silicate | - | - | - | - | - | 20 | - | - | - | - | - |
| | Catioinic polymerizable compound | Tetramethyleneglycol diglycidyl ether | - | - | - | - | - | - | - | - | - | - | - |
| | | 3-Ethyl-3-hydroxymethyl oxetane | - | - | - | - | - | - | - | 10 | - | - | - |
| Composition (parts by weight) | | 1,4-Bis[[(3-ethyl-3-oxetanyl) methoxy]methyl} benzene | | - | - | - | - | - | - | - | - | - | - |
| | | Bisphenol A-type epoxy resin | - | - | - | - | - | - | - | - | - | - | - |
| | Photo-cationic polymerization initiator | (Tolylcumyl)iodonium tetrakis (pentafluorophenyl)borate | 1 | 1 | 1 | 1 | 1 | 1 | 1 | 1 | 1 | 1 | 1 |
| | Cure retarder | 18-Crown-6 | - | - | - | - | - | - | 1 | - | - | - | - |
| | Photosensitize | Thioxanthone compound | 0.2 | 0.2 | 0.2 | 0.2 | 0.2 | 0.2 | 0.2 | 0.2 | 0.2 | 0.2 | - |
| | Filler | Talc | - | 30 | 30 | 30 | 30 | 30 | 30 | 30 | - | - | 30 |
| | | Mica | - | - | - | - | - | - | - | - | 30 | - | - |
| | | Silica | - | - | - | - | - | - | - | - | - | 30 | - |
| | Glass transition temperature | | 110 | 110 | 105 | 85 | 120 | 115 | 110 | 105 | 110 | 110 | 90 |
| | Iodine stain resistance | | ○ | ○ | ○ | ⊚ | △ | ○ | ○ | ○ | ○ | ○ | ○ |
| Evaluation | Sealability (Percentage of weight of electrolyte after heating to before heating) | Durability test 1 (85°C, 500 hours) | 92 | 98 | 98 | 95 | 96 | 95 | 98 | 97 | 98 | 95 | 94 |
| | | Durability test 2 (85°C, relative humidity: 85%, 500 hours) | 118 | 103 | 103 | 104 | 103 | 105 | 103 | 101 | 103 | 112 | 112 |

**[Table 2]**

| | | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|
| | | Di{1-ethyl(3-oxetanyl)} methyl ether | 10 | 90 | - | - | - | - | - |
| | | Hydrogenated bisphenol A-type epoxy resin | 90 | 10 | 50 | 50 | 70 | - | 50 |
| | | Dicyclopentadiene-type epoxy resin | - | - | 50 | - | - | - | - |
| | | Oxetane silicate | - | - | - | 50 | - | - | - |
| | Cationic polymerizable compound | Tetramethyleneglycol diglycidyl ether | - | - | - | - | 30 | - | - |
| | | 3-Ethyl-3-hydroxymethyl oxetane | - | - | - | - | - | - | - |
| Composition (parts by weight) | | 1,4-Bis{[(3-ethyl-3-oxetanyl) methoxy]methyl} benzene | - | - | - | - | - | - | 50 |
| | | Bisphenol A-type epoxy resin | - | - | - | - | - | 100 | - |
| | Photo-cationic polymerization initiator | (Tolylcumyl)iodonium tetrakis (pontafluorophonyl)borate | 1 | 1 | 1 | 1 | 1 | 1 | 1 |
| | Silane coupling agent | γ-Glycidoxypropyltrimethoxysilane | 1 | 1 | 1 | 1 | 1 | 1 | 1 |
| | Cure retarder | 18-Crown-6 | - | - | - | - | - | - | - |
| | Photosensitizer | Thioxanthone-type compound | 0.2 | 0.2 | 0.2 | 0.2 | 0.2 | 0.2 | 0.2 |
| | Filler | Talc | 30 | 30 | 30 | 30 | 30 | 30 | 30 |
| | | Mica | - | - | - | - | - | - | - |
| | | Silica | - | - | - | - | - | - | - |
| | Glass transition temperature | | 125 | 70 | 125 | 115 | 60 | 130 | 110 |
| Evaluation | Iodine stain resistance | | × | ⊚ | × | △ | × | × | × |
| | Sealability (Percentage of weight of electrolyte after heating to before heating) | Durability test 1 (85°C, 500 hours) | 98 | 81 | 95 | 92 | 42 | 95 | 85 |
| | | Durability test 2 (85°C, relative humidity: 85%, 500 hours) | 103 | 118 | 108 | 115 | 57 | 104 | 111 |

### INDUSTRIAL APPLICABILITY

The present invention provides a sealing agent for a dye-sensitized solar cell, which is excellent in sealability and iodine stain resistance, and also provides a dye-sensitized solar cell produced using the sealing agent for a dye-sensitized solar cell.

### EXPLANATION OF SYMBOLS

- 1, 1': Glass substrate
- 2, 2': Transparent electrode layer
- 3: Semiconductor layer
- 4: Photosensitive dye
- 5: Electrolyte
- 6: Vapor-deposited platinum film
- 7: Sealing agent
- 8: Sealant
- 9: Glass thin section

## Claims

1. A sealing agent for a dye-sensitized solar cell, which contains a cationic polymerizable compound and a photo-cationic polymerization initiator,
the sealing agent containing 20 to 80 parts by weight of a saturated hydrocarbon compound having an ether structure in a main chain and two or more oxetanyl groups in a molecule, in 100 parts by weight of the cationic polymerizable compound.

2. The sealing agent for a dye-sensitized solar cell according to claim 1,
wherein the saturated hydrocarbon compound having an ether structure in a main chain and two or more oxetanyl groups in a molecule has a structure represented by a formula (1): 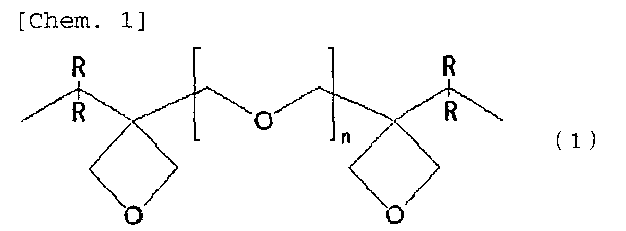 R being hydrogen or an alkyl group containing 1 to 6 carbon atoms, and n being an integer from 1 to 12, in the formula (1).

3. The sealing agent for a dye-sensitized solar cell according to claim 1 or 2,
wherein the cationic polymerizable compound further contains an epoxy compound having a saturated polycyclic hydrocarbon group or two or more cyclohexyl groups in a repeating unit.

4. The sealing agent for a dye-sensitized solar cell according to claim 1, 2, or 3,
wherein the cationic polymerizable compound further contains an epoxy compound having a hydroxyl group or an oxetane compound having a hydroxyl group.

5. The sealing agent for a dye-sensitized solar cell according to claim 1, 2, 3, or 4,
wherein the cationic polymerizable compound further contains an epoxy compound having a silicone skeleton or an oxetane compound having a silicone skeleton.

6. The sealing agent for a dye-sensitized solar cell according to claim 1, 2, 3, 4, or 5,
which contains a filler.

7. The sealing agent for a dye-sensitized solar cell according to claim 6,
wherein the filler is inorganic tabular powder.

8. The sealing agent for a dye-sensitized solar cell according to claim 1, 2, 3, 4, 5, 6, or 7,
which contains a silane coupling agent.

9. The sealing agent for a dye-sensitized solar cell according to claim 1, 2, 3, 4, 5, 6, 7, or 8,
which contains a cure retarder.

10. A dye-sensitized solar cell,
which is obtained using the sealing agent for a dye-sensitized solar cell according to claim 1, 2, 3, 4, 5, 6, 7, 8, or 9.
